# EUROPEAN PATENT APPLICATION

(11) **EP 2 706 460 A1**
(43) Date of publication of application: **12.03.2014**
(21) Application number: 13183949.0
(22) Date of filing: 11.09.2013
(51) Int. Cl.: G06F 12/02

(54) **Apparatus and method for storing data in terminal**

(30) Priority: 11.09.2012 KR 20120100602
(71) Applicant: Samsung Electronics Co., Ltd, Gyeonggi-do 443-742 (KR)
(72) Inventor: Shin, Hee-Sub, 443-742 Gyeonggi-do (KR)
(74) Representative: Jenkins, Richard Gavin

(57) **Abstract**

Provided is an apparatus and method for storing data in a terminal are provided. The apparatus includes a processor for sending a first command to a memory to instruct storage of data in a Single-Level Cell (SLC) area of the memory if a function requiring high-speed storage of large amounts of data is selected; and the memory for storing received data in the SLC area regardless of a size of the data, upon receiving the first command from the processor.

## Description

### BACKGROUND OF THE INVENTION

### 1. Field of the Invention

The present invention relates generally to an apparatus and method for storing data, for example in a terminal, and more particularly, although not exclusively, to a data storage apparatus and method for quickly storing large amounts of data that require storage at a high speed in a terminal.

### 2. Description of the Related Art

A Multi-Level Cell (MLC) NAND flash memory refers to a NAND flash memory capable of storing a plurality of bits in one memory cell. Compared to the existing Single-Level Cell (SLC) NAND flash memory, the MLC NAND flash memory costs less since it can provide more storage capacity per unit silicon area. Therefore, the MLC NAND flash memory has been widely adopted to products such as portable memory cards and Solid State Drives (SSDs).

However, the MLC NAND flash memory is slower than the SLC NAND flash memory in terms of the programming speed. In other words, compared to the SLC NAND flash memory that has a simple programming process as its cells store only one of the two states of '0' and '1', the MLC NAND flash memory has a complex programming process and a longer programming time, since it needs to be programmed whereby one memory cell may have more subdivided states. Therefore, the MLC NAND flash memory exhibits a poor write performance, which is about a half of that of the SLC NAND flash memory.

In addition, the MLC NAND flash memory has shorter life span than the SLC NAND flash memory because the MLC NAND flash memory has a greater programming stress level than the SLC NAND flash memory as applied to its memory cells during the writing process. Therefore, while the SLC NAND flash memory typically guarantees 1,000,000 Programming/Erase (P/E) cycles, the MLC NAND flash memory guarantees about 10,000 P/E cycles, which much shorter than that of the SLC NAND flash memory.

Due to its poor write performance and low P/E cycle, the MLC NAND flash memory may not be appropriate for applications that require high-speed write performance and/or high reliability.

For example, if the write operation occurs very frequently, the MLC NAND flash memory will significantly decrease in life span due to its low guaranteed P/E cycle, failing to ensure the reliability of the stored data. In addition, due to its low write performance, the MLC NAND flash memory may hardly be applied to applications that need to quickly store large amounts of data.

In order to overcome these and other shortcomings of the MLC NAND flash memory, the latest NAND flash memory products are allowed to use each of the blocks constituting the NAND flash memory in either an SLC mode or an MLC mode. For example, in applications requiring high-speed write performance, the NAND flash memory products may operate in the SLC mode in which the products have high speed while sacrificing storage capacity. On the contrary, in applications requiring storing large amounts of data such as multimedia data, the NAND flash memory products may operate in the MLC mode in which the products may increase storage capacity while sacrificing speed. In other words, the latest NAND flash memory may drive an arbitrary block of the memory in either the SLC mode or the MLC mode.

These MLC NAND flash memory functions are often used in a flash translation layer. The flash translation layer is software that makes it possible to use the NAND flash memory in a similar way to a disk drive. The flash translation layer may store frequently written data in the SLC mode, and store infrequently written data in the MLC mode. To this end, the flash translation layer secures some blocks operating in the SLC mode and uses them as a kind of buffer space. This operation method will be referred herein to as an SLC buffer technique.

The SLC buffer technique has the effect of absorbing inputs/outputs which are disadvantageous to the MLC NAND flash memory. Advantageously, the frequently written data may be processed in the SLC mode having a high P/E cycle, since it may cause frequent erase/write operations of the NAND flash memory. However, the flash translation layer may have difficulty in determining in which of an SLC area and an MLC area it should write the write-requested data, since there is no means to accurately estimate the data update frequency at a reasonable cost.

Due to these difficulties, the conventional flash translation layer using the SLC buffer technique determines the area in which the data is to be stored, based on the length of the write-requested data. For example, upon request for writing data which is smaller in size (or length) than a predetermined threshold, the requested data is stored in an SLC area, and upon request for writing other data, the requested data is stored in an MLC area. Generally, while small-sized data tends to be frequently updated, like the metadata of a file system, large-sized data such as MP3 data and video data are typically not updated once they are written. Therefore, this method is available, given the limited P/E cycle of the area operating in the MLC mode. In addition, it is more reasonable to store small-sized data such as the metadata of the file system in the SLC mode, since this data needs to be quickly written due to its close relationship with the performance of a computer system.

However, if the conventional flash translation layer using the SLC buffer technique simply determines the SLC/MLC areas based only on data length, small-sized data may be unconditionally written in the SLC buffer (or SLC area) and large-sized data may be unconditionally written in the MLC buffer (or MLC area). Therefore, the conventional flash translation layer may not properly handle a request for writing large amounts of data that needs to be written quickly.

### SUMMARY OF THE INVENTION

It is an aim of certain embodiments of the invention to solve, mitigate or obviate, at least partly, at least one of the problems and/or disadvantages associated with the prior art. Certain embodiments aim to provide at least one of the advantages described below.

An aim of certain embodiments of the present invention is to address at least one of the above-mentioned problems and/or disadvantages and to provide at least one of the advantages described below. Accordingly, an aim of certain embodiments of the present invention is to provide a data storage apparatus and method for quickly storing large amounts of data that require storage at a high speed in a terminal.

In accordance with an aspect of the present invention, there is provided an apparatus for storing data, and in certain embodiments the apparatus is for storing data in a terminal. The apparatus includes a processor for sending a first command to a memory to instruct storage of data in a Single-Level Cell (SLC) area of the memory if a first function (e.g. a function requiring high-speed storage of large amounts of data) is selected; and the memory for storing received data in the SLC area regardless of a size of the data (in other words, irrespective of the size, amount, or quantity of the data received, the memory is adapted to keep/continue storing that data in the SLC area), upon receiving the first command from the processor. Thus, the memory, which comprises a SLC area, is responsive to the first command to store subsequently received data in the SLC area, irrespective of the amount, size, or quantity of the received data, and continue storing that received data in the SLC area until receiving a further command.

It will be appreciated that a large amount of data may be an amount of data greater than or equal to a predetermined threshold amount. Similarly, high speed storage may be data storage at a rate greater than or equal to a predetermined threshold rate.

Another aspect of the invention provides data storage apparatus comprising:
a memory comprising a Single-Level Cell (SLC) area; and
a processor configured to send a first command to the memory to instruct storage of data in the Single-Level Cell (SLC) area of the memory if a first function (e.g. a function requiring high-speed storage of large amounts of data) is selected,
wherein the memory is adapted to store received data in the SLC area regardless of a size of the received data, in response to receiving the first command from the processor.

Another aspect of the invention provides data storage apparatus comprising:
a memory comprising a Single-Level Cell (SLC) area and a Multi-Level Cell (MLC) area; and
a processor configured to send a first command to the memory,
wherein the memory is responsive to the first command to operate in a mode in which all data received by the memory is stored in the SLC area.

In certain embodiments, the processor is adapted to send a second com mand to the memory, and the memory is responsive to the second command to operate in a mode in which data received by the memory is stored either in the SLC area or MLC area, depending on the size of the received data.

Another aspect provides a terminal comprising apparatus in accordance with any one of the above-mentioned aspects.

In accordance with another aspect of the present invention, there is provided a method for storing data, e.g. for storing data in a terminal. The method includes sending, by a processor, a first command to a memory to instruct storage of data in a Single-Level Cell (SLC) area of the memory if a first function (e.g. a function requiring high-speed storage of large amounts of data) is selected; and storing received data in the SLC area of the memory regardless of a size of the data, upon receiving the first command from the processor.

Another aspect of the invention provides a computer program comprising instructions arranged, when executed, to implement a method and/or apparatus in accordance with any one of the above-described aspects. A further aspect provides machine-readable storage storing such a program.

### BRIEF DESCRIPTION OF THE DRAWINGS

The above and other aspects, features and advantages of embodiments of the present invention will be more apparent from the following description taken in conjunction with the accompanying drawings, in which:
FIG. 1 illustrates a structure of a terminal according to an embodiment of the present invention;
FIG. 2 is a flowchart illustrating a process of storing large amounts of data at high speed by a processor in a terminal according to an embodiment of the present invention;
FIG. 3 is a flowchart illustrating a process of storing large amounts of data at high speed by a memory in a terminal according to a first embodiment of the present invention;
FIGs. 4A and 4B are flowcharts illustrating a process of storing large amounts of data at high speed by a memory in a terminal according to a second embodiment of the present invention; and
FIGs. 5A and 5B are flowcharts illustrating a process of storing large amounts of data at high speed by a memory in a terminal according to a third embodiment of the present invention.

Throughout the drawings, like reference numerals will be understood to refer to like parts, components, and structures.

### DETAILED DESCRIPTION OF EMBODIMENTS OF THE PRESENT INVENTION

The following description with reference to the accompanying drawings is provided to assist in a comprehensive understanding of embodiments of the present invention as defined by the claims and their equivalents. It includes various specific details to assist in that understanding but these are to be regarded as mere examples. Accordingly, those of ordinary skilled in the art will recognize that various changes and modifications of the embodiments described herein can be made without departing from the scope and spirit of the invention. In addition, descriptions of well-known functions and constructions may be omitted for clarity and conciseness.

The terms and words used in the following description and claims are not limited to their dictionary meanings, but, are merely used to enable a clear and consistent understanding of the invention. Accordingly, it should be apparent to those skilled in the art that the following description of embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

The terminals, to which embodiments of the present invention are applicable, may include mobile terminals and fixed terminals. The mobile terminals, easy-to-carry portable electronic devices, may include, but are not limited to, video phones, cellular phones, smart phones, International Mobile Telecommunication 2000 (IMT-2000) terminals, Wideband Code Division Multiple Access (WCDMA) terminals, Universal Mobile Telecommunication Service (UMTS) terminals, Personal Digital Assistants (PDAs), Portable Multimedia Players (PMPs), Digital Multimedia Broadcasting (DMB) terminals, E-Book readers, portable computers (for example, laptop computers, tablet computers and the like), digital cameras or the like. The fixed terminals may include desktop Personal Computers (PCs) and the like.

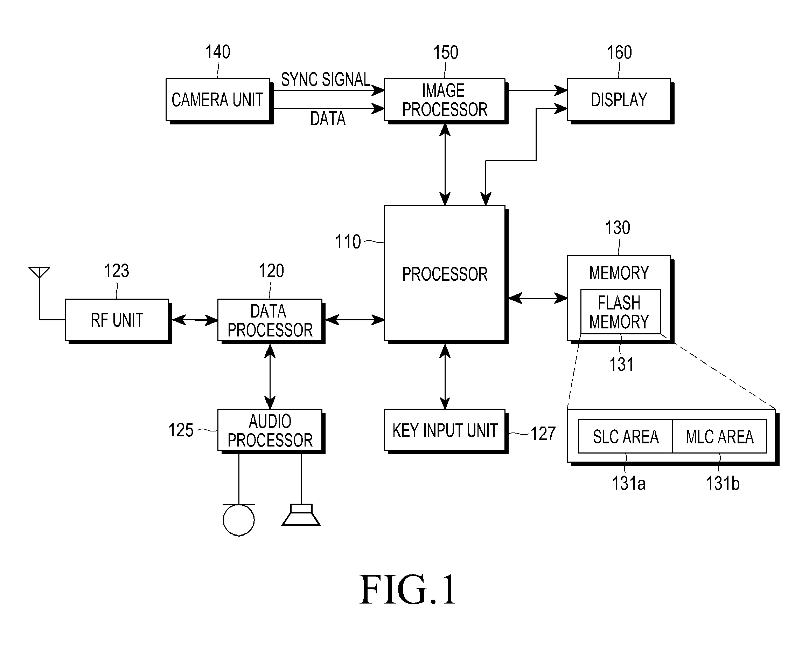

FIG. 1 illustrates a structure of a terminal according to an embodiment of the present invention.

Referring to FIG. 1, a Radio Frequency (RF) unit 123 is responsible for wireless communication of the terminal. The RF unit 123 includes an RF transmitter for up-converting a frequency of transmission signals and amplifying the up-converted transmission signals, and an RF receiver for low-noise-amplifying received signals and down-converting a frequency of the amplified received signals. A data processor 120 includes a transmitter for coding and modulating the transmission signals and a receiver for demodulating and decoding the received signals. In other words, the data processor 120 may be comprised of a modulator-demodulator (modem) and a coder-decoder (codec). The codec includes a data codec for processing packet data and the like, and an audio codec for processing audio signals such as voice. An audio processor 125 plays received audio signals output from the audio codec in the data processor 120, using a speaker, and transfers transmission audio signals picked up by a microphone to the audio codec in the data processor 120.

A key input unit 127 includes numeric/character keys for entering numeric/character information, and function keys for setting various functions.

A camera unit 140 includes a camera sensor for capturing image data and converting the captured optical image signals into electrical image signals, and a signal processor for converting analog image signals captured by the camera sensor into digital image data. The camera sensor may be a Charge-Coupled Device (CCD) or Complementary Metal-Oxide Semiconductor (CMOS) sensor, and the signal processor may be implemented with a Digital Signal Processor (DSP). The camera sensor and the signal processor may be implemented either integrally or separately.

An image processor 150 performs Image Signal Processing (ISP) to display image signals output from the camera unit 140 on a display 160. The ISP may include gamma correction, interpolation, spatial variation, image effects, image scaling, Automatic White Balance (AWB), Automatic Exposure (AE), Automatic Focus (AF) and the like. The image processor 150 processes the image signals output from the camera unit 140 on a frame basis, in a process known to those skilled in the art and outputs the frame image data depending on the characteristics and size of the display 160. The image processor 150 is assumed to have an On-Screen Display (OSD) function, and may output OSD data depending on the size of the displayed screen, under control of a processor 110.

The display 160 displays, on its screen, the image signals output from the image processor 150 and the user data output from the processor 110. A Liquid Crystal Display (LCD) may be used for the display 160. When implemented as a touch screen, the LCD may serve as an input unit. In this case, the same keys as those on the key input unit 127 may be displayed on the display 160, and the key input unit may be eliminated. The processor 110 controls the overall operation of the terminal.

In accordance with embodiments of the present invention, if a first function, e.g. a function requiring high-speed (or relatively high-speed) storage of large (or relatively large) amounts of data, is selected by a user in the terminal, the processor 110 sends a first command to a flash memory 131 to instruct storage of data in a Single-Level Cell (SLC) area 131a.

Upon termination of the function requiring high-speed storage of large amounts of data, the processor 110 sends a second command to the flash memory 131 to instruct storage of data in either of the SLC area 131a and a Multi-Level Cell (MLC) area 131b included in the flash memory 131, depending on the size of the data. The processor 110 then sends a third command to the flash memory 131 to instruct shifting of all the data stored in the SLC area 131a to the MLC area 131b.

A memory 130 may be comprised of a program memory and a data memory. In accordance with embodiments of the present invention, the program memory may store control programs for controlling the overall operation of the terminal, and control programs for storing large amounts of data required to be stored at high speed, in the SLC area 131a of the flash memory 131. The data memory may temporarily store the data generated during execution of the control programs.

The memory 130 may include volatile memories and non-volatile memories. The present invention relates to the non-volatile memories for storing data, and more particularly, to storing data in the NAND flash memory 131 among the non-volatile memories.

The flash memory 131 is partitioned into the SLC area 131a having high storage speed and low storage capacity, and the MLC area 131b having low storage speed and high storage capacity. Thus, in certain embodiments the memory comprises an SLC area and an MLC area.

In accordance with embodiments of the present invention, the SLC area 131a stores large amounts of received data, if the flash memory 131 switches to a second mode upon receiving the first command from the processor 110. The SLC area 131a stores small amounts of received data, which is less than or equal to a threshold, if the flash memory 131 switches to a first mode upon receiving the second command from the processor 110.

The MLC area 131b stores large amounts of received data, which is greater than or equal to a threshold, if the flash memory 131 switches to the first mode upon receiving the second command from the processor 110.

Upon receiving the first command from the processor 110 in the first mode in which received data is stored in either the SLC area 131a and the MLC area 131b included in the flash memory 131, depending on the size of the data, the flash memory 131 switches to the second mode in which all of the received data is stored in the SLC area 131a. Upon receiving a data storage command from the processor 110 in the second mode of the flash memory 131, the flash memory 131 stores the received data in the SLC area 131a.

Upon receiving the second command from the processor 110 in the second mode of the flash memory 131, the flash memory 131 switches to the first mode. Upon receiving a data storage command from the processor 110 in the first mode of the flash memory 131, the flash memory 131 stores the received data in the MLC area 131b if its size is greater than or equal to a first threshold, and the received data is stored in the SLC area 131a if its size is less than the first threshold.

The term 'first threshold' as used herein may refer to a threshold that is set in advance to store data in either the SLC area 131a and the MLC area 131b, depending on the size of the data. Therefore, the first threshold may be set differently depending on the storage capacity allocated to each of the SLC area 131a and the MLC area 131b which are partitioned in the flash memory 131.

Upon receiving the third command to instruct shifting all the data stored in the SLC area 131a to the MLC area 131b in the first or second modes, the flash memory 131 shifts all the data stored in the SLC area 131a to the MLC area 131b.

Further, the flash memory shifts all the data stored in the SLC area 131a to the MLC area 131b, if there is no read/write operation in the flash memory (131) for a predetermined time, namely, if the flash memory switches to idle state.

Upon receiving the first command from the processor 110 in the first mode in which received data is stored in either the SLC area 131a and the MLC area 131b included in the flash memory 131, depending on the size of the data, the flash memory 131 switches to the second mode if the storage capacity of the SLC area 131a is greater than or equal to a second threshold. Upon receiving a data storage command from the processor 110 in the second mode of the flash memory 131, the flash memory 131 stores the received data in the SLC area 131a.

Upon receiving the first command from the processor 110 in the first mode, the flash memory 131 secures the maximum storage space for high-speed storage by shifting the data stored in the SLC area 131a to the MLC area 131b, if the storage capacity of the SLC area 131a is less than the second threshold, and then switches to the second mode. Upon receiving a data storage command from the processor 110 in the second mode, the flash memory 131 automatically stores the received data in the SLC area 131a.

The term 'second threshold' as used herein may refer to a threshold that is set in advance to secure the maximum storage capacity for high-speed storage before performing high-speed storage, and may also refer to a threshold that is set in advance to secure the space for storing all the data (i.e., large amounts of data) required to be stored at high speed upon reception of the first command. Depending on the second threshold, all the data stored in the SLC area 131a may be shifted to the MLC area 131b, or some of the data stored in the SLC area 131a may be shifted to the MLC area 131b to secure a storage space that is set in advance for high-speed storage.

Upon receiving the first command from the processor 110 in the first mode in which received data is stored in either the SLC area 131a and the MLC area 131b included in the flash memory 131, depending on the size of the data, the flash memory 131 switches to the second mode in which the data is stored in the SLC area 131a. Upon receiving a data storage command from the processor 110 in the second mode of the flash memory 131, the flash memory 131 automatically stores the received data in the SLC area 131a. After the storage operation, if the storage space of the SLC area 131a is less than a third threshold, the flash memory 131 shifts the data stored in the SLC area 131a to the MLC area 131b to secure the space for storing the data required to be stored at high speed.

The term 'third threshold' as used herein may refer to a threshold that is set in advance to secure in real time the space for storing data required to be stored at high speed, during execution of high-speed storage, and may also refer to a threshold that is set in advance to secure the space capable of storing data received later by checking the storage capacity of the SLC area 131a after data storage, during execution of high-speed storage upon reception of the first command. Depending on the third threshold, all the data stored in the SLC area 131a may be shifted to the MLC area 131b, or some of the data stored in the SLC area 131a may be shifted to the MLC area 131b to secure in real time a storage space for received data during execution of high-speed storage.

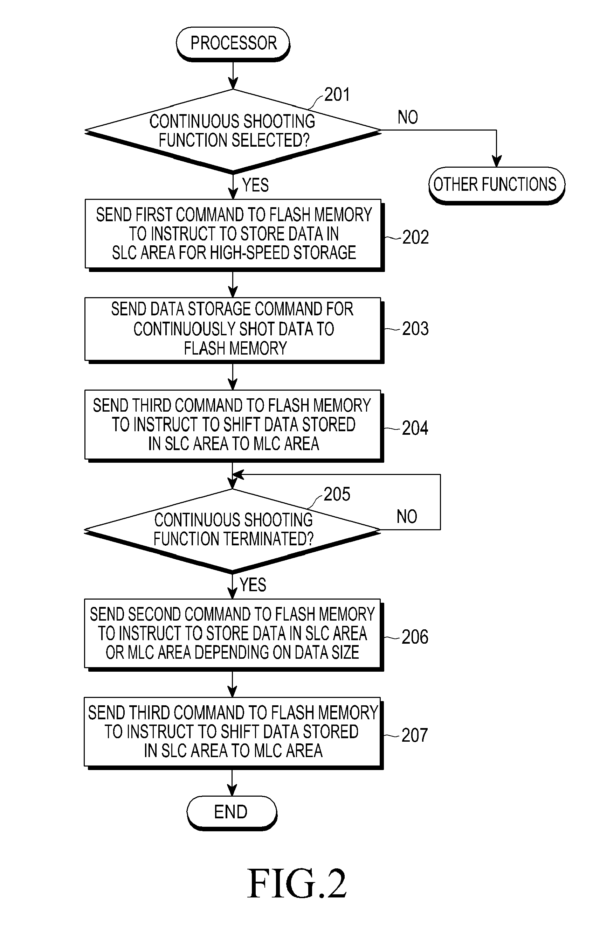

An operation of quickly storing large amounts of data in the flash memory in the above-described terminal will be described in detail with reference to FIGs. 2 to 5.

Although a continuous shooting function using camera unit 140 will be considered as the function requiring high-speed storage of large amounts of data (a first function) in certain embodiments of the present invention, the present invention may be applied in the same way not only to the continuous shooting function, but also to other functions, in particular, although not exclusively, other functions that need to quickly store large amounts of data temporarily for a short period of time.

FIG. 2 is a flowchart illustrating a process of storing large amounts of data at high speed by a processor in a terminal according to an embodiment of the present invention.

Referring to FIG. 2, if a continuous shooting function is selected by a user in the terminal, the processor 110 detects the selection of a function requiring high-speed storage of large amounts of data in step 201, and sends a first command to the flash memory 131 to instruct storage of data in the SLC area 131a of the flash memory 131, for high-speed storage, in step 202. If the processor does not detect selection of the high speed storage function in step 201, other functions may be executed.

After sending the first command to the flash memory 131, the processor 110 sends a data storage command to the flash memory 131 to instruct storage of the data or images which are sequentially received by the continuous shooting, in step 203.

While sending the data storage command for the continuously shot data or images to the flash memory 131, the processor 110 sends a third command to the flash memory 131 to instruct shifting all the data stored in the SLC area 131a to the MLC area 131b, at regular intervals, in step 204. By sending the third command to the flash memory 131, the processor 110 shifts all the data stored in the SLC area 131a of the flash memory 131 to the MLC area 131b, thereby preventing the continuously shot images from failing to be stored in the SLC area 131a due to the shortage of storage space in the SLC area 131a.

If the continuous shooting function is terminated by the user while sending the data storage command for the continuously shot images to the flash memory 131, the processor 110 detects the termination of the continuous shooting function in step 205, and sends a second command to the flash memory 131 to instruct storage of data in either the SLC area 131a and the MLC area 131b, depending on the size of the data, in step 206.

After a lapse of a predetermined time after sending the second command, the processor 110 sends the third command to the flash memory 131 to instruct shifting all the data stored in the SLC area 131a to the MLC area 131b, in step 207. By sending the third command to the flash memory 131, the processor 110 shifts all the data stored in the SLC area 131a of the flash memory 131 to the MLC area 131b, thereby making it possible to quickly store large amounts of data in the SLC area 131a, if the function requiring high-speed storage of large amounts of data is selected later.

Further, the flash memory shifts all the data stored in the SLC area 131a to the MLC area 131b, if there is no read/write operation in the flash memory (131) for a predetermined time, namely, if the flash memory switches to idle state.

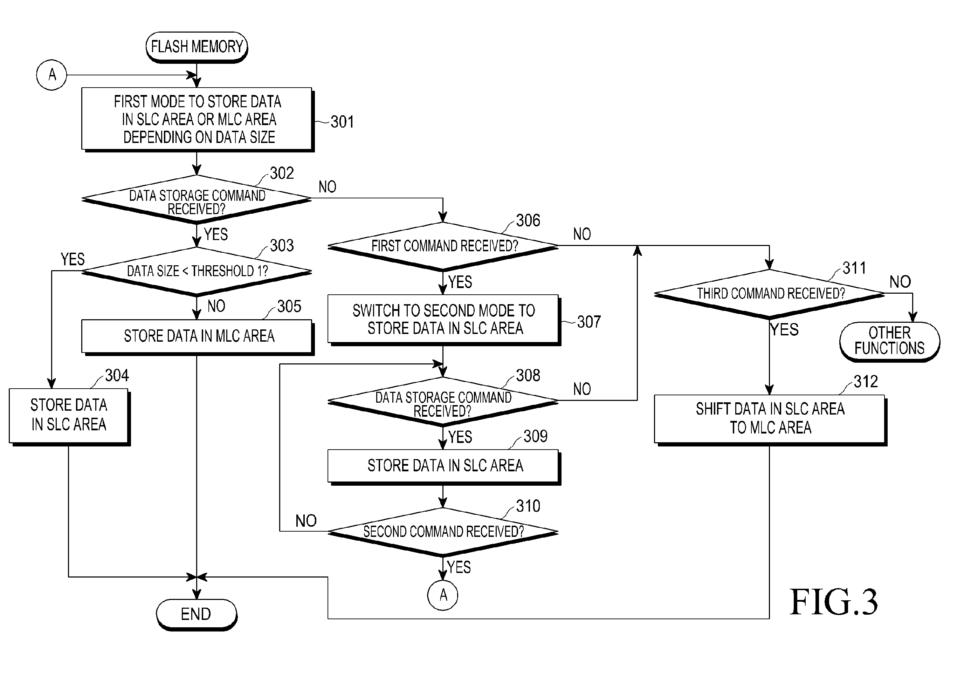

The above-described operation of quickly storing large amounts of data in the flash memory by the processor, depending on the type of the command that is sent to the flash memory, will be described in detail with reference to FIGs. 3 to 5.

FIG. 3 is a flowchart illustrating a process of storing large amounts of data at high speed by a memory in a terminal according to a first embodiment of the present invention.

Referring to FIG. 3, upon receiving a data storage command from the processor 110 in step 302 when the flash memory 131 is in a first mode in step 301, the flash memory 131 compares a size of received data to be stored, with a first threshold in step 303. If the size of the received data is less than the first threshold, the flash memory 131 automatically stores the received data in the SLC area 131a in step 304. On the contrary, if the size of the received data is greater than or equal to the first threshold in step 303, the flash memory 131 automatically stores the received data in the MLC area 131b in step 305.

The first mode refers to a mode in which received data is automatically stored in either the SLC area 131a and the MLC area 131b included in the flash memory 131 depending on the size of the data, and the first mode may be set as a default mode of the flash memory 131.

If the data storage command is not received in step 302, a determination is made in step 306 if a first command is received from the processor 110. Upon receiving the first command from the processor 110 in step 306, the flash memory 131 switches, in step 307, to a second mode in which it stores all the received data to be stored, in the SLC area 131a at all times regardless of the size of the data.

Upon receiving a data storage command from the processor 110 in step 308, the flash memory 131 automatically stores the received data to be stored, in its SLC area 131a in step 309.

Upon receiving a second command from the processor 110 in step 310 while storing all the received data to be stored, in its SLC area 131a in the second mode, the flash memory 131 switches, in step 301, back to the first mode in which received data is stored in either the SLC area 131a and the MLC area 131b, depending on the size of the data.

If the first command is not received in the step 306, or if the data storage command is not received in step 308, a determination is made in step 311 if a third command is received from the processor 110. Upon receiving the third command from the processor 110 in the first or second mode in step 311, the flash memory 131 shifts all the data stored in the SLC area 131a to the MLC area 131b in step 312, thereby securing the storage space where data is to be stored in the SLC area 131a.

Further, the flash memory shifts all the data stored in the SLC area 131a to the MLC area 131b, if there is no read/write operation in the flash memory (131) for a predetermined time, namely, if the flash memory switches to idle state.

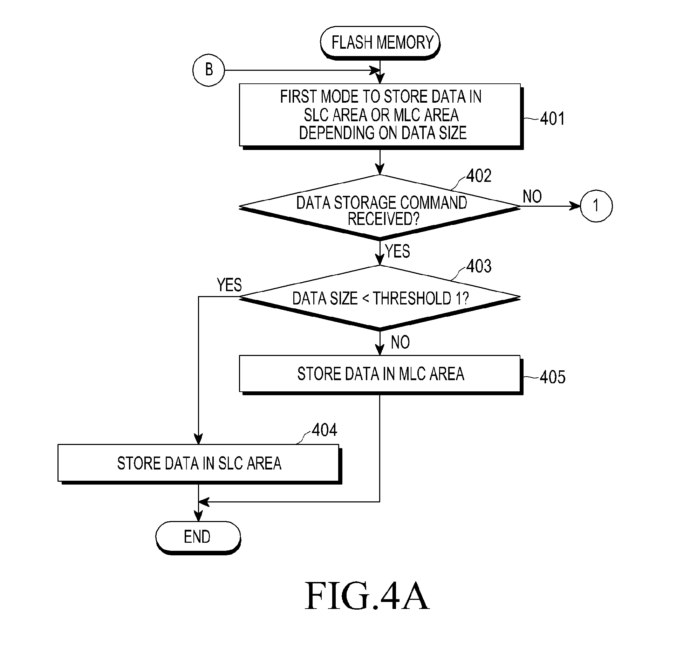

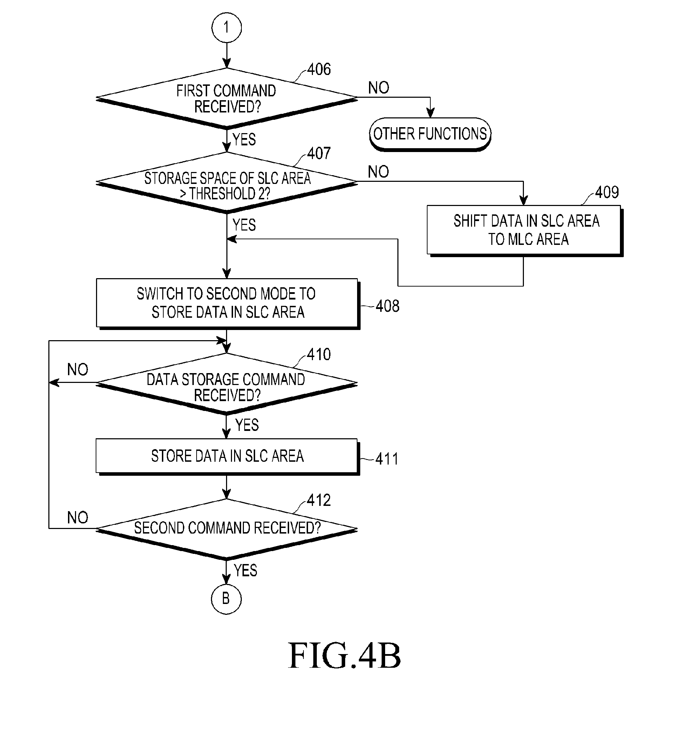

FIGs. 4A and 4B are flowcharts illustrating a process of storing large amounts of data at high speed by a memory in a terminal according to a second embodiment of the present invention.

Referring to FIGs. 4A and 4B, upon receiving a data storage command from the processor 110 in step 402 when the flash memory 131 is in a first mode in step 401, the flash memory 131 compares a size of received data to be stored, with a first threshold in step 403. If the size of the received data is less than the first threshold, the flash memory 131 automatically stores the received data in the SLC area 131a in step 404. On the contrary, if the size of the received data is greater than or equal to the first threshold, the flash memory 131 automatically stores the received data in the MLC area 131b in step 405.

The first mode refers to a mode in which received data is automatically stored in either the SLC area 131a and the MLC area 131b included in the flash memory 131 depending on the size of the data, and the first mode may be set as a default mode of the flash memory 131.

If the data storage command is not received in step 402, a determination is made in step 406 if a first command is received from the processor 110. Upon receiving the first command from the processor 110 in step 406, the flash memory 131 compares a storage space available in the SLC area 131a with a second threshold in step 407. If the storage space available in the SLC area 131a is greater than the second threshold, the flash memory 131 switches, in step 408, to a second mode in which it stores all the received data to be stored, in the SLC area 131a at all times regardless of the size of the data.

On the other hand, if the storage capacity available in the SLC area 131a is less than or equal to the second threshold in step 407, the flash memory 131 shifts the data stored in the SLC area 131a to the MLC area 131b in step 409, securing the space where data can be stored in the SLC area 131a. The data that is stored in the SLC area 131a and shifted to the MLC area 131b may include all the data stored in the SLC area 131a, or some of the data stored in the SLC area 131a, in which a storage space may be secured for large amounts of received data to be stored at high speed.

Once the storage space for large amounts of data to be stored at high speed is acquired in the SLC area 131a, the flash memory 131 switches, in step 408, to the second mode in which it stores all the received data to be stored, in the SLC area 131a at all times regardless of the size of the data.

Upon receiving a data storage command from the processor 110 in step 410, the flash memory 131 automatically stores the received data to be stored, in its SLC area 131a in step 411.

Upon receiving a second command from the processor 110 in step 412, while storing all the received data to be stored in its SLC area 131a in the second mode, the flash memory 131 switches, in step 401, back to the first mode in which received data is stored in either the SLC area 131a and the MLC area 131b, depending on the size of the data.

Although it is assumed in the second embodiment of the present invention that the flash memory shifts data in the SLC area to the MLC area by itself without receiving from the processor a third command to instruct shifting data in the SLC area to the MLC area, the flash memory may shift data in the SLC area to the MLC area by receiving the third command from the processor.

Further, the flash memory shifts all the data stored in the SLC area 131a to the MLC area 131b, if there is no read/write operation in the flash memory (131) for a predetermined time, namely, if the flash memory switches to idle state.

The flash memory may shift data in the SLC area to the MLC area by itself at regular intervals not only in the second mode, but in the first mode.

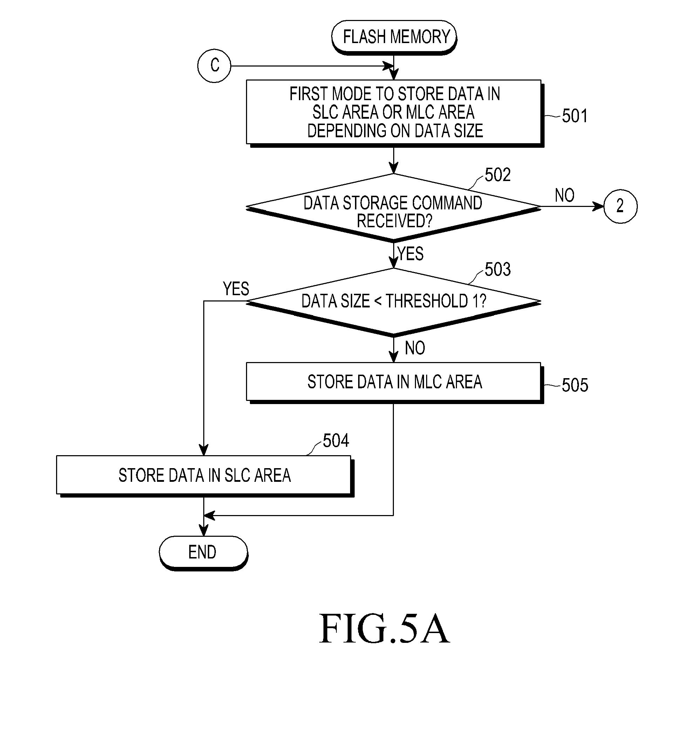

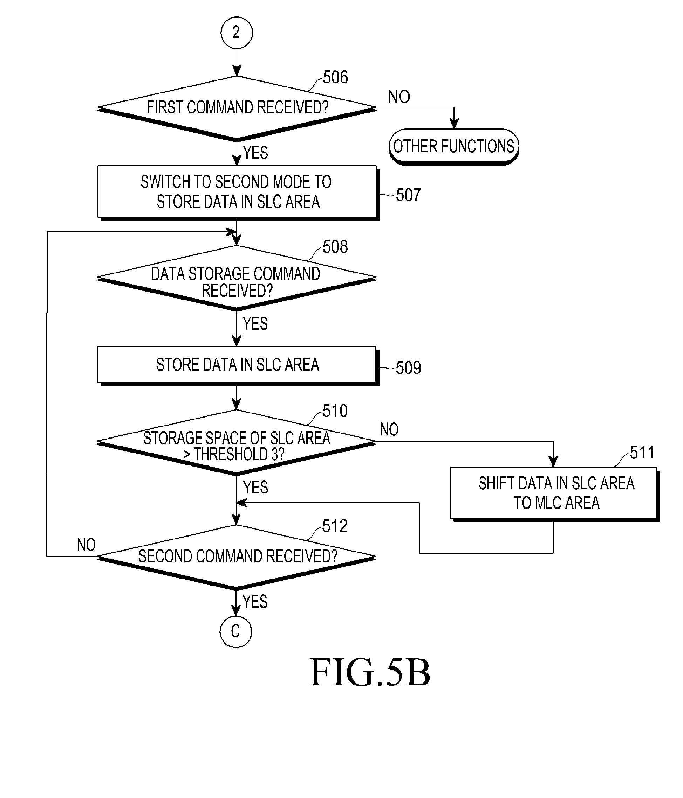

FIGs. 5A and 5B are flowcharts illustrating a process of storing large amounts of data at high speed by a memory in a terminal according to a third embodiment of the present invention.

Referring to FIGs. 5A and 5B, upon receiving a data storage command from the processor 110 in step 502 when the flash memory 131 is in a first mode in step 501, the flash memory 131 compares a size of received data to be stored, with a first threshold in step 503. If the size of the received data is less than the first threshold, the flash memory 131 automatically stores the received data in the SLC area 131a in step 504. On the contrary, if the size of the received data is greater than or equal to the first threshold, the flash memory 131 automatically stores the received data in the MLC area 131b in step 505.

The first mode refers to a mode in which received data is automatically stored in either the SLC area 131a and the MLC area 131b included in the flash memory 131, depending on the size of the data, and the first mode may be set as a default mode of the flash memory 131.

If the data storage command is not received in step 502, a determination is made in step 506 if a first command is received from the processor 110. Upon receiving the first command from the processor 110 in step 506, the flash memory 131 switches, in step 507, to a second mode in which it stores all the received data to be stored, in the SLC area 131a at all times regardless of the size of the data.

Upon receiving a data storage command from the processor 110 in step 508, the flash memory 131 automatically stores the received data to be stored, in its SLC area 131a in step 509.

After storing data in the SLC area 131a, the flash memory 131 compares a storage space available in the SLC area 131a with a third threshold in step 510. If the storage space available in the SLC area 131a is less than or equal to the third threshold, the flash memory 131 shifts the data stored in the SLC area 131a to the MLC area 131b in step 511, securing the space where data may be stored in the SLC area 131a. The data that is stored in the SLC area 131a and shifted to the MLC area 131b may include all the data stored in the SLC area 131a, or some of the data stored in the SLC area 131a, in which a storage space may be secured for large amounts of received data to be stored later.

If the storage space available in the SLC area 131a is greater than the third threshold in step 510, a determination is made in step 512 if a second command is received from the processor 110. Upon receiving the second command from the processor 110 in step 512 while securing a storage space for large amounts of data in the SLC area 131a and storing all the received data to be stored, in its SLC area 131a in the second mode, the flash memory 131 switches, in step 501, back to the first mode in which received data is stored in either the SLC area 131a and the MLC area 131b, depending on the size of the data.

Although it is assumed in the third embodiment of the present invention that the flash memory shifts data in the SLC area to the MLC area by itself without receiving from the processor a third command to instruct shifting data in the SLC area to the MLC area, the flash memory may shift data in the SLC area to the MLC area by receiving the third command from the processor.

Further, the flash memory shifts all the data stored in the SLC area 131a to the MLC area 131b, if there is no read/write operation in the flash memory (131) for a predetermined time, namely, if the flash memory switches to idle state.

The flash memory may shift data in the SLC area to the MLC area by itself at regular intervals not only in the second mode, but in the first mode.

Embodiments of the present invention may be implemented as computer-readable codes in computer-readable recording media. The computer-readable recording media may include all kinds of recording devices that store computer-readable data. Typical examples of the recording media may include Read Only Memory (ROM), Random Access Memory (RAM), optical discs, magnetic tapes, floppy discs, hard discs, non-volatile memories and the like, and may also include recording media implemented in the form of carrier waves (for example, transmission over the Internet). The computer-readable recording media may be distributed over the computer systems connected by a network, and the computer-readable codes may be stored and executed in a distributed manner.

As is apparent from the foregoing description, the data storage apparatus and method of certain embodiments of the present invention may quickly store large amounts of data that require temporary storage in a memory at high speed in a terminal.

It will be appreciated that embodiments of the present invention can be realized in the form of hardware, software or a combination of hardware and software. Any such software may be stored in the form of volatile or non-volatile storage such as, for example, a storage device like a ROM, whether erasable or rewritable or not, or in the form of memory such as, for example, RAM, memory chips, device or integrated circuits or on an optically or magnetically readable medium such as, for example, a CD, DVD, magnetic disk or magnetic tape or the like. It will be appreciated that the storage devices and storage media are embodiments of machine-readable storage that are suitable for storing a program or programs comprising instructions that, when executed, implement embodiments of the present invention. Accordingly, embodiments provide a program comprising code for implementing apparatus or a method as claimed in any one of the claims of this specification and a machine-readable storage storing such a program. Still further, such programs may be conveyed electronically via any medium such as a communication signal carried over a wired or wireless connection and embodiments suitably encompass the same.

Throughout the description and claims of this specification, the words "comprise" and "contain" and variations of the words, for example "comprising" and "comprises", means "including but not limited to", and is not intended to (and does not) exclude other moieties, additives, components, integers or steps.

Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith.

It will be also be appreciated that, throughout the description and claims of this specification, language in the general form of "X for Y" (where Y is some action, activity or step and X is some means for carrying out that action, activity or step) encompasses means X adapted or arranged specifically, but not exclusively, to do Y.

While the invention has been shown and described with reference to certain embodiments thereof, it will be understood by those skilled in the art that various changes in form and details may be made therein without departing from the spirit and scope of the invention as defined by the appended claims and their equivalents.

## Claims

1. An apparatus for storing data in a terminal, the apparatus comprising:
a processor configured to send a first command to a memory to instruct storage of data in a Single-Level Cell (SLC) area of the memory if a first function is selected; and
the memory for storing received data in the SLC area regardless of a size of the data, upon receiving the first command from the processor.

2. The apparatus of claim 1, wherein upon termination of the function, the processor sends a second command to the memory to instruct storage of data in either the SLC area and a Multi-Level Cell (MLC) included in the memory, depending on a size of the data.

3. The apparatus of claim 1 or claim 2, wherein the processor sends a third command to the memory to instruct shifting the data stored in the SLC area to an MLC area.

4. The apparatus of any preceding claim, wherein upon receiving the first command from the processor in a first mode in which the received data is stored in either the SLC area and an MLC area included in the memory depending on a size of the data, the memory switches to a second mode in which the data is stored in the SLC area of the memory, and upon receiving a data storage command from the processor in the second mode, the memory stores the received data in the SLC area of the memory.

5. The apparatus of claim 4, wherein upon receiving a second command from the processor in the second mode, the memory switches to the first mode, and upon receiving a data storage command from the processor in the first mode, the memory stores the received data in the MLC area if a size of the received data is greater than or equal to a first threshold, and stores the received data in the SLC area of the memory if the size of the received data is less than the first threshold.

6. The apparatus of claim 4 or claim 5, wherein upon receiving a third command in the first or second modes to instruct shifting the data stored in the SLC area to the MLC area, or upon occurring ideal state in the memory for a predetermined time, the memory shifts the data stored in the SLC area to the MLC area.

7. The apparatus of claim 1, wherein upon receiving the first command from the processor in a first mode in which the received data is stored in either the SLC area and an MLC area included in the memory depending on a size of the data, the memory switches to a second mode if a storage space of the SLC area is greater than or equal to a second threshold, and upon receiving a data storage command from the processor in the second mode, the memory stores the received data in the SLC area of the memory.

8. The apparatus of claim 7, wherein upon receiving the first command from the processor in the first mode, the memory switches to the second mode after securing a maximum storage space for high-speed storage by shifting the data stored the SLC area to the MLC area, if the storage space of the SLC area is less than the second threshold, and upon receiving a data storage command from the processor in the second mode, the memory stores the received data in the SLC area of the memory.

9. The apparatus of claim 1, wherein upon receiving the first command from the processor in a first mode in which the received data is stored in either the SLC area and an MLC area included in the memory depending on a size of the data, the memory switches to a second mode in which the data is stored in the SLC area of the memory, and upon receiving a data storage command from the processor in the second mode, the memory stores the received data in the SLC area of the memory, and secures a space for storing data required to be stored at high speed, by shifting the data stored in the SLC area to the MLC area, if a storage space of the SLC area is less than a third threshold.

10. A method for storing data in a terminal, the method comprising:
sending, by a processor, a first command to a memory to instruct storage of data in a Single-Level Cell (SLC) area of the memory if a first function is selected; and
storing received data in the SLC area of the memory regardless of a size of the data, upon receiving the first command from the processor.

11. The method of claim 10, further comprising:
upon termination of the function requiring high-speed storage of large amounts of data, sending, by the processor, a second command to the memory to instruct storage of data in either the SLC area and a Multi-Level Cell (MLC) included in the memory, depending on a size of the data.

12. The method of claim 10 or claim 11, further comprising:
sending, by the processor, a third command to the memory to instruct shifting the data stored in the SLC area to an MLC area.

13. The method of any one of claims 10 to 12, wherein storing the received data comprises:
upon receiving the first command from the processor in a first mode of the memory in which the received data is stored in either the SLC area and an MLC area included in the memory depending on a size of the data, switching to a second mode in which the data is stored in the SLC area of the memory; and
upon receiving a data storage command from the processor in the second mode, storing the received data in the SLC area of the memory.

14. The method of claim 13, further comprising:
upon receiving a second command from the processor in the second mode, switching to the first mode;
upon receiving a data storage command from the processor in the first mode, storing the received data in the MLC area of the memory if a size of the received data is greater than or equal to a first threshold; and
storing the received data in the SLC area of the memory if the size of the received data is less than the first threshold.

15. The method of claim 13 or claim 14, further comprising:
upon receiving from the processor a third command in the first or second modes to instruct shifting the data stored in the SLC area to the MLC area, or upon occurring ideal state in the memory for a predetermined time, shifting the data stored in the SLC area to the MLC area.

16. The method of claim 10, wherein storing the received data comprises:
upon receiving the first command from the processor in a first mode of the memory in which the received data is stored in either the SLC area and an MLC area included in the memory depending on a size of the data, switching to a second mode if a storage space of the SLC area is greater than or equal to a second threshold; and
upon receiving a data storage command from the processor in the second mode, storing the received data in the SLC area of the memory.

17. The method of claim 16, further comprising:
upon receiving the first command from the processor in the first mode, switching to the second mode after securing a maximum storage space for high-speed storage by shifting the data stored the SLC area to the MLC area, if the storage space of the SLC area is less than the second threshold; and
upon receiving a data storage command from the processor in the second mode, storing the received data in the SLC area of the memory.

18. The method of claim 10, wherein storing the received data comprises:
upon receiving the first command from the processor in a first mode of the memory in which the received data is stored in either the SLC area and an MLC area included in the memory depending on a size of the data, switching to a second mode in which the data is stored in the SLC area of the memory;
upon receiving a data storage command from the processor in the second mode, storing the received data in the SLC area of the memory; and
securing a space for storing data required to be stored at high speed, by shifting the data stored in the SLC area to the MLC area, if a storage space of the SLC area is less than a third threshold.

19. A non-transitory computer-readable recording medium having programs stored thereon, which when executed by a processor, perform a method comprising:
sending, by a processor, a first command to a memory to instruct storage of data in a Single-Level Cell (SLC) area of the memory if a first function is selected; and
storing received data in the SLC area of the memory regardless of a size of the data, upon receiving the first command from the processor.

20. An apparatus, method, or recording medium in accordance with any preceding claim, wherein the first function is a function requiring high-speed storage of large amounts of data.
